# EUROPÄISCHE PATENTANMELDUNG

(11) **EP 4 310 614 A1**
(43) Veröffentlichungstag der Anmeldung: **24.01.2024**
(21) Anmeldenummer: 22185499.5
(22) Anmeldetag: 18.07.2022
(51) Int. Cl.: G05B 23/02

(54) **VERFAHREN BZW. VORRICHTUNG ZUR VERWENDUNG EINES DATENMODELLS ZUR ÜBERWACHUNG BZW. BEWERTUNG EINES GURTFÖRDERERS**

(71) Anmelder: Siemens Aktiengesellschaft, 80333 München (DE)
(72) Erfinder: Hellmuth, Torsten, 91058 Erlangen (DE); Mächler, Peter, 01662 Meißen (DE)
(74) Vertreter: Siemens Patent Attorneys

(57) **Zusammenfassung**

Bei einem Verfahren zur Analyse eines Gurtförderers (1) wird ein Datenmodell (3) verwendet, wobei das Datenmodell (3) ein digitales Abbild des Gurtförderers (1) betrifft, wobei ein erster Funktionswert (45) des Gurtförderers (1) ermittelt wird, wobei der erste Funktionswert (45) und ein zweiter Funktionswert (46) zur Analyse des Gurtförderers verwendet werden, wobei der zweite Funktionswert (46) den Gurtförderer (1) oder einen weiteren Gurtförderer (2) betrifft, wobei die Funktionswerte (45,46) in einem zeitlichen Abstand ermittelt werden oder wobei die Funktionswerte (45,46) unterschiedliche Gurtförderer (1,2) betreffen. Durch die beschriebene Normierung kann ein Benchmark zur Performancebewertung eines Gurtförderers, wie auch zur Performancebewertung für Gurtförderer mit ähnlicher Transportaufgabe erstellt werden.

## Beschreibung

Die Erfindung betrifft ein Verfahren bzw. eine Vorrichtung zur Verwendung eines Datenmodells zur Überwachung bzw. Bewertung eines Gurtförderers und/oder einer Vielzahl von Gurtförderern. Sowohl die Überwachung wie auch die Bewertung des Gurtförderers bzw. der Vielzahl von Gurtförderern betrifft deren Analyse. Die vorliegende Erfindung betrifft ferner ein Computerprogrammprodukt zum Durchführen des Verfahrens. Die Erfindung betrifft insbesondere ein Verfahren zur Performancebewertung (also der Bewertung einer Performance) eines Gurtförderers oder einer Vielzahl von Gurtförderern in der Mining-Industrie, also im Bergbau, mit Hilfe eines digitalen Zwillings. Der digitale Zwilling ist ein Beispiel für ein Datenmodell bzw. ein Beispiel für die Verwendung eines Datenmodells.

Das Verfahren bzw. die Vorrichtung zur Verwendung eines Datenmodells zur Überwachung bzw. Bewertung zumindest eines Gurtförderers betrifft insbesondere eine Zustandsüberwachung und/oder eine Zustandsvorhersage für den zumindest einen Gurtförderer. Die Zustandsüberwachung, auch Condition Monitoring (CM) genannt, dient insbesondere dem Zweck, den "Gesundheitszustand" von Komponenten, Maschinen, Assets, Anlagenteilen und/oder Anlagen zu beobachten und durch Analyse von CM-bezogenen Daten Aussagen zu Veränderungen dieses Zustandes zu treffen. Zu diesem Zweck werden z.B. Industrial-Internet-Of-Things-Plattformen, kurz: IIoT-Plattformen, genutzt, um von Geräten übermittelte Daten zu erfassen, dezentral zu speichern, Rohdaten zu visualisieren, Daten zu analysieren, und/oder Ergebnisse der Analyse zu visualisieren. Auch lokale Lösungen sind möglich.

Die kontinuierliche Zustandsüberwachung und Analyse von Parametern eines Gurtförderers hilft z.B. mögliche Schäden vorherzusagen und so im Idealfall gar nicht erst auftreten zu lassen. Dies betrifft insbesondere wichtige Parameter wie Vibration oder Leistungsaufnahme). Bei einem Gurtförderer können Sensoren Messwerte (z.B. Kühltemperatur, Vibration, elektrische Spannung und Strom eines Stromrichters und/oder eines Motors und/oder ein Drehmoment) an unterschiedlichen Stellen in der Anlage aufnehmen und diese an eine Auswerteeinheit, wie beispielsweise das jeweilige Condition-Monitoring-System (CMS) und/oder eine Steuerung, weiterleiten. Das CMS kann auch in die Steuerung integriert sein. Zumindest ein Teil der Messdatenverarbeitung kann dabei durch die Auswerteeinheit erfolgen. Dazu können etwa Überwachungsfunktionen, wie beispielsweise Trendanzeigen, Prognosen sowie das Aufzeichnen von Rohdaten, zählen.

Das Datenmodell kann auch als ein "digitaler Zwilling" bezeichnet werden. Der digitale Zwilling ist insbesondere eine Darstellung eines realen Systems in einem digitalen Kontext (IT-System), z.B. mit der Möglichkeit, die Zeit "einzustellen" (d.h. das System schnell oder langsam von der Vergangenheit über die Gegenwart bis in die Zukunft zu betrachten). Das Datenmodell kann Einzelsysteme, Teilsysteme wie auch Gesamtsysteme betreffen.

Gurtförderer werden insbesondere als ein Transportmittel im Bereich der Grundstoffindustrie, in Häfen, in Kraftwerken, in Minen usw. eingesetzt. Gurtförderer sind wohl die in der Rohstoffindustrie (Mining + Cement) mit am häufigsten eingesetzten Transportmittel um Schüttgut (z.B. Erz, Kohle, Kies, Zement) effizient von einem Ort zu einem anderen Ort zu transportieren. Kostendruck, Anforderungen zur Leistungserhöhung und Forderungen zur Betriebsoptimierung sind wesentliche Treiber bzw. Anforderungen für den Betrieb bzw. den Betreiber von Gurtförderern oder anderen industriellen Anlagen.

Für die Erfassung und Bewertung von technischen Aspekten eines Gurtförderers gibt es Lösungen, wie z.B. eine Erfassung von Bauteiltemperaturen und eine Bestimmung von Trends, um z.B. einen Verschleiß von Bauteilen zu erkennen oder Ausfallwahrscheinlichkeiten zu ermitteln. In Verbindung mit Daten aus dem Betriebsprozess, wie z.B. Fördermenge und Betriebsdauer, lassen sich KPI's (KPI: Key Performance Index) bestimmen, mit denen auch Aussagen zur Anlagenperformance gewonnen werden können.

Anforderungen an industrielle Anlagen, wie diese insbesondere im Bereich Bergbau und Zement eingesetzt werden bzw. vorhanden sind, kann man beispielsweise in zwei Gruppen unterteilen. Diese zwei Gruppen können auch als eine Art Hauptgruppen bezeichnet werden.

Eine Gruppe beinhaltet z.B. zumindest einen der folgenden maschinentechnischen Aspekte: Erhöhung der Einsatzdauer der Bauteile, Vermeidung von Ausfällen, Verringerung von Verschleiß, etc..

Eine zweite Gruppe beinhaltet z.B. zumindest einen der folgenden prozesstechnischen Aspekte: Vermeidung von Stillständen, Verringerung der Anlagenlaufzeit ohne Materialtransport (keine Leerfahrten), schneller Hochlauf, etc..

Für die erste Gruppe können unterschiedliche Lösungen zur Überwachung und/oder Zustandsbewertung von einzelnen Bauteilen genutzt werden, wie z.B. die Erfassung von Temperaturen oder Schwingungen, insbesondere von unterschiedlichen Bauteilen, wie Lager von Transportrollen, Lager von Motoren, elektrische Motoren, usw.. Damit erfolgt beispielsweise eine einfache Grenzwertüberwachung, um unmittelbare Schäden zu verhindern oder durch entsprechende Analyse dieser Messdaten Trends zu ermitteln, um z.B. Aussagen zum Verschleiß oder Erkenntnisse zur Ausfallwahrscheinlichkeit des einzelnen Bauteils zu gewinnen.

Für die zweite Gruppe können also z.B. Daten aus einem Betriebsprozess der industriellen Anlage, wie z.B. Fördermenge, Energieverbrauch, Betriebsdauer, herangezogen werden, um KPI's zur Bewertung einer Anlagenperformance zu gewinnen. KPI's können beispielsweise von einem Hersteller, einem Betreiber bzw. einem Bediener der industriellen Anlage nach eigenem Ermessen definiert werden. Dadurch kann es aber schwieriger werden unterschiedliche Anlagen von insbesondere unterschiedlichen Betreibern zu vergleichen.

Die Vergleichbarkeit von Gurtförderern kann beispielsweise aus den folgenden Gründen schwierig sein. Gurtförderer können sich durch einen oder mehrere der folgenden Aspekte unterscheiden: Topologie (insbesondere bezogen auf die Topologie des Aufstellungsortes), Förderleistung, Bauteile usw.. Zudem gibt es eine weitere Vielzahl von Einflussgrößen und komplexen Zusammenhängen, die in eine Überwachung bzw. Bewertung der Anlage einfließen können.

Es ist eine Aufgabe der Erfindung einen Gurtförderer besser zu analysieren.

Eine Lösung der Aufgabe ergibt sich bei einem Verfahren nach Anspruch 1 bzw. bei einem Gurtförderer nach Anspruch 13, bzw. bei einem Computerprogrammprodukt nach Anspruch 15. Ausgestaltungen ergeben sich insbesondere nach den Ansprüchen 2 bis 12 und 14.

In bzw. bei einem Verfahren zur Analyse eines Gurtförderers wird ein Datenmodell verwendet. Das Datenmodell ist ein digitales Abbild des Gurtförderers bzw. betrifft dieses. Mit dem digitalen Abbild, welches auch als digitaler Zwilling bezeichnet werden kann, kann der Gurtförderer ganz oder teilweise digital abgebildet werden. Es handelt sich also um ein Abbild eines realen Gurtförderers, wobei der Gurtförderer sich beispielsweise in einer Inbetriebsetzungsphase, einer Betriebsphase, einer Leerlaufphase, einer Reparaturphase befindet. Bei dem Verfahren wird ein erster Funktionswert des Gurtförderers ermittelt. Die Ermittlung des ersten Funktionswertes erfolgt insbesondere mithilfe des Datenmodells. Zur Analyse des Gurtförderers werden der erste Funktionswert und ein zweiter Funktionswert verwendet. Der zweite Funktionswert betrifft den Gurtförderer (welcher im Folgenden auch als erster Gurtförderer bezeichnet werden kann) oder einen weiteren Gurtförderer (also einen zweiten Gurtförderer und/oder einen dritten Gurtförderer, etc.). Es kann also einen ersten Gurtförderer und einen weiteren, zweiten Gurtförderer geben. Der weitere Gurtförderer ist beispielsweise an einem anderen Ort wie der erste Gurtförderer. Weiterhin kann der weitere Gurtförderer zeitlich parallel zum ersten Gurtförderer betrieben werden, wie auch in der Vergangenheit betrieben worden sein, wobei der weitere Gurtförderer beispielsweise stillgelegt oder demontiert worden sein kann. Als ein weiterer Gurtförderer kann auch ein Gurtförderer bezeichnet werden, welcher umgebaut wurde und als umgebauter Gurtförderer den ersten Gurtförderer repräsentiert. Als ein weiterer Gurtförderer kann auch ein Gurtförderer bezeichnet werden, welcher ein anderes Material und/oder eine andere Menge von Material transportiert. Dies betrifft insbesondere den gleichen Gurtförderer, welcher zu unterschiedlichen Zeiten zu einem unterschiedlichen Einsatz kommt, also z.B. ein anderes Material transportiert. Die Funktionswerte werden insbesondere in einem zeitlichen Abstand ermittelt und/oder die Funktionswerte betreffen unterschiedliche Gurtförderer. Unterschiedliche Gurtförderer sind dabei also beispielsweise Gurtförderer, welche an einem anderen Ort sind oder in unterschiedlichen Zeiträumen betrieben werden. Damit unterscheidet sich beispielsweise ein Gurtförderer nach einem Umbau dieses Gurtförderers von einem ersten Zustand, sodass ein erster Gurtförderer und ein zweiter Gurtförderer verglichen werden können. Beispiele für zeitliche Abstände bei der Ermittlung der Funktionswerte sind:
- minütlich,
- stündlich (insbesondere für Prozessinformation),
- monatlich (insbesondere für eine langfristige Bewertung von durchgeführten Maßnahmen wie z.B. einem Wechsel von Teilen, die Verwendung eines besseren Lagers, die Verwendung eines stärkeren Motors, der Verwendung eines anderen Fördergurtes, etc.)
- jährlich (insbesondere für Gründe wie beim Unterpunkt "monatlich" und/oder insbesondere für eine Ermittlung abhängig von der Jahreszeit, einer Temperatur, Schnee, Regen, etc.)

Der Funktionswert kann auch einen Wert oder eine Vielzahl von Werten betreffen, die z.B. stündlich ermittelt/gemessen werden, um Kurven über die Zeit zu ermitteln, mit denen Trendentwicklungen sichtbar werden.

In einer Ausgestaltung des Verfahrens wird zur Analyse eine Normierung durchgeführt. Die Normierung betrifft dabei insbesondere den Funktionswert bzw. eine Vielzahl von Funktionswerten. Durch die Normierung kann eine Vergleichbarkeit von Gurtförderern erzielt werden. Ein erster Gurtförderer ist also mittels der Normierung mit einem zweiten Gurtförderer vergleichbar, auch wenn sich der erste Gurtförderer vom zweiten Gurtförderer unterscheidet. Eine Unterscheidung ergibt sich beispielsweise durch eine unterschiedliche Hubhöhe und/oder eine unterschiedliche Länge des Gurtbandes des Gurtförderers und/oder eine ein unterschiedliches gefördertes Material und/oder eine Reparatur, etc.. Durch die beschriebene Normierung kann ein Benchmark zur Performancebewertung eines Gurtförderers, wie auch zur Performancebewertung für Gurtförderer mit ähnlicher Transportaufgabe, erstellt werden.

Anlagen in der Mining-Industrie werden insbesondere nach technisch, physikalischen bzw. mathematischen Regeln dimensioniert, wobei diese Regeln bei Gurtförderern, z.B. in der DIN oder der CEMA, definiert sind. Dies ermöglicht insbesondere eine standardisierte Normierung von Gurtförderern. Für verschiedene Gurtförderer kann ein digitaler Zwilling entwickelt werden, der auf den oben genannten Regeln basiert und z.B. mit Messdaten validiert werden kann, damit er sich genauso verhält, wie sein realer Zwilling. Dies kann auf Basis der Dimensionierungsdaten erfolgen bzw. auf der Nutzung erster Messungen während der Inbetriebnahme oder kurz danach. Auf diese Art und Weise kann man z.B. einen Urzustand des Gurtförderers in dem digitalen Zwilling festhalten.

In einer Ausgestaltung des Verfahrens wird auf einen Betriebszustand des Gurtförderers normiert. Ein Beispiel für einen Betriebszustand ist die Geschwindigkeit, mit welcher der Gurtförderer betrieben wird.

In einer Ausgestaltung des Verfahrens wird auf einen Kennwert eines Materials normiert, wobei der Kennwert insbesondere das Gewicht und/oder die Menge des Materials betrifft bzw. dessen Wert darstellt. Das Material ist das mit dem Gurtförderer geförderte, also transportierte Material. Die Normierung auf das Material, bzw. auf den Kennwert des Materials, betrifft beispielsweise die Beladung durch das Material und/oder die spezifische Dichte des Materials. Durch eine unterschiedliche Beladung des Gurtförderers mit Material ergeben sich Beladungsklassen. Beladungsklassen können auch als Lastklassen bezeichnet werden. Beladungsklassen können sich beispielsweise wie Folgt voneinander unterscheiden bzw. folgende Parameter beinhalten:
- Mengenunterschiede bei gleicher Geschwindigkeit
- Metermasse = Förderleistung (z.B. in Tonne/Stunde) / Geschwindigkeit (z.B. in Meter/Sekunde)

Durch die Normierung in Beladungsklassen kann der gleiche Gurtförderer so normiert werden, dass Veränderungen des Funktionswertes erkannt werden. Der Funktionswert kann für jede Beladungsklasse bestimmt werden, zeitliche Veränderungen des Funktionswertes erlauben dann Schlussfolgerungen auf Performance und/oder Zustand des Gurtförderers.

In einer Ausgestaltung des Verfahrens wird auf eine Hubhöhe normiert. Die Hubhöhe ist die Höhe, welche mittels des Gurtförderers zu überwinden ist bzw. überwunden wird. Die Hubhöhe kann einen positiven oder negativen Wert haben oder Null sein. Mittels des Gurtförderers können unterschiedliche Höhenprofile eines Terrains überwunden werden, sodass sich, insbesondere durch ein auf und ab des Terrains, unterschiedliche Einzelhubhöhen ergeben, welche in einer zusammengefassten Hubhöhe resultieren. Durch die Normierung auf die Hubhöhe ist es möglich unterschiedliche Gurtförderer miteinander zu vergleichen. Die Funktionswerte werden insbesondere für die jeweilige Geschwindigkeit und den jeweiligen Beladungsfall ermittelt und auf die Hubhöhe normiert. Somit ist die Vergleichbarkeit unterschiedlicher Gurtförderer möglich. Es ist dabei insbesondere möglich die Förderleistung mit zu berücksichtigen, da diese in den Beladungsklassen indirekt enthalten ist.

In einer Ausgestaltung des Verfahrens betrifft die Normierung den ersten Funktionswert des Gurtförderers (also insbesondere des ersten Gurtförderers) und den zweiten Funktionswert des weiteren Gurtförderers. Das Verfahren ist also auf mehrere Gurtförderer anwendbar, wobei die Normierung den Vergleich verschiedener Gurtförderer ermöglicht.

In einer Ausgestaltung des Verfahrens unterscheiden sich die Gurtförderer in Ihrer Länge und/oder Förderleistung nicht um mehr als 50 %, insbesondere 25 %, wobei die Gurtförderer insbesondere ähnliche Transportaufgaben haben. Durch die Vorgabe einer maximalen Unterscheidung erleichtert sich die Vergleichbarkeit und/oder verringert sich der Normierungsaufwand. Zu vergleichende Gurtförderer sind also insbesondere für ähnliche Transportaufgaben eingesetzt. Ähnliche Transportaufgaben ergeben sich bei folgenden Gurtförderern, welche sich in der Länge des zurückzulegenden Weges unterscheiden:
- Langstreckenförderer in Kilometer (Transportfunktion von A nach B über einen oder mehr Kilometer)
- Lagerplatzförderer auf einem Lagerplatz insbesondere in 100-ten Metern (Transportfunktion von A nach B)
- Bunkerabzugsförderer (Materialaustragsfunktion aus Bunkern oder Silos).

In einer Ausgestaltung des Verfahrens ist der Funktionswert eine Energieleistungskennzahl. Die Energieleistungskennzahl kann auch als ein Energie Performance Indicator (EnPI) bezeichnet werden. Die Energieleistungskennzahl ist ein KPI mit dem die Performance eines Gurtförderers beschrieben werden kann. Da sich Gurtförderer aber sehr stark unterscheiden und es eine Vielzahl von Einflussgrößen und komplexen Zusammenhängen gibt, die sich auf diese Kennzahl, also den EnPI auswirken, ist eine Vergleichbarkeit unterschiedlicher Gurtförderer kaum möglich, falls keine Normierung durchgeführt wird. Durch die Normierung ergibt sich die Vergleichbarkeit von Gurtförderern. Dies bedeutet beispielsweise, dass ein Betreiber des Gurtförderers einen EnPI ermitteln kann und dann auch einschätzen kann, ob der ermittelte Wert gut oder schlecht ist, da ein Benchmark zur Verfügung steht. Es ist also möglich eine Energieleistungskennzahl eines Gurtförderers zu ermitteln, bei dem insbesondere durch die Nutzung eines digitalen Zwillings in Verbindung mit realen Messdaten des Gurtförderers, ein Benchmark ermittelt wird, der insbesondere den Betreiber sofort erlaubt die Performance seines Gurtförderers zu bewerten.

Wird beispielsweise ein digitaler Zwilling mit Messdaten aus dem realen Anlagenbetrieb des Gurtförderers betrieben (z.B. Fördermenge, Geschwindigkeit, Betriebsdauer) können u.a. KPI's wie der EnPI bestimmt werden. Diese Leistungskennzahlen beschreiben dann die theoretische Performance des Gurtförderers ohne Berücksichtigung von Veränderungen zum Urzustand (also z.B. zum Zustand kurz nach der ersten Inbetriebsetzung). Einflüsse von Verschleiß, Temperatur, Sommer oder Winterbetrieb, Ausrichtezustand des Gurtförderers (bei rückbaren Gurtförderern) oder andere Veränderungen bleiben unberücksichtigt. Der reale EnPI kann insbesondere auf Basis von Messwerten ermittelt werden und mit dem theoretischen EnPI verglichen werden. Der Vergleich erlaubt dann eine sofortige Beurteilung der Performance der betrachteten Anlage, also des Gurtförderers.

In einer Ausgestaltung des Verfahrens wird eine technische Abweichung und/oder eine technische Störung erkannt. Beispiele für technische Abweichungen sind:
- ein veränderter Leistungsbedarf der Antriebe
- ein erhöhter Laufwiderstand des Gurtes
- etc..

Beispiele für technische Störungen sind:
- ein ungeplanter Stillstand und/oder eine Unterbrechung durch Schäden an Bauteilen
- ein ungeplanter Stillstand und/oder eine Unterbrechung durch Materialüberschüttungen, Gurtschieflauf, etc.
- etc..

In einer Ausgestaltung des Verfahrens wird eine prozessuale Abweichung und/oder Störung erkannt. Wird dergleichen erkannt, können Gegenmaßnahmen vorgeschlagen bzw. automatisch durchgeführt werden.

Beispiele für prozessuale Abweichungen sind:
- die Materialzufuhr schwankt
- die Materialzufuhr wird insbesondere häufig unterbrochen
- der Gurt läuft nur mit Teilbeladung
- eine schlechte Energieperformance, da für weniger Material trotzdem hohe Antriebsleistung verbraucht wird
- eine Veränderung des Betriebsverhaltens durch Temperaturänderungen (z.B. durch eine tiefe Temperatur; dies führt zu dickflüssigerem Schmiermittel und dadurch zu einer Erhöhung des Lagerlaufwiderstandes)

Beispiele für prozessuale Störungen sind:
- häufige Unterbrechungen, welche die Performance des Gurtförderers verschlechtern,
- häufige Verlangsamung des Transportes, welche auch die Performance des Gurtförderers verschlechtern.

Ursachen für Streuungen und/oder Abweichungen können auch in der Anlagensteuerung liegen. Zum Beispiel führen falsch eingestellte Grenzwerte zu häufigen Störungen und somit zu Unterbrechungen.

Die ermittelten Funktionswerte und der daraus abzuleitende Trend, gibt ein Indiz zur Performance und somit zum Zustand des Gurtförderers. Daraus lassen sich Informationen für einen einzelnen Gurtförderer gewinnen, indem die Funktionswerte mittels Normierung der Geschwindigkeit und der Zuordnung in die beschriebenen Beladungsklassen bestimmt werden. Diese Normierung erlaubt es die Funktionswerte bei gleichen Betriebsbedingungen zu vergleichen. Die weitere Normierung auf die Hubhöhe erlaubt es auch "ähnliche" Gurtförderer untereinander zu vergleichen. Damit ist ein Leistungs-/Performancevergleich (Benchmarking)unter Gurtförderern möglich. Wie oben beschrieben liefert der Funktionswert ein Indiz zum Zustand des Gurtförderers, für eine konkrete Ursachenermittlung (Technik oder Prozess) sind dann insbesondere weitere Untersuchungen erforderlich.

In einer Ausgestaltung des Verfahrens wird ein Eingriff in den Betrieb des Gurtförderers durchgeführt. Dabei ist insbesondere ein realer, also physikalisch vorhandener, Gurtförderer gemeint. Durch den Eingriff kann die Performance, also die Leistungsfähigkeit des Gurtförderers positiv beeinflusst werden.

In einer Ausgestaltung des Verfahrens wird die Wirksamkeit des Eingriffs analysiert. Durch diese Analyse wird es möglich die Performance des Gurtförderers schrittweise zu verbessern. Zur Analyse der Wirksamkeit des Eingriffs wird beispielsweise der zweite Funktionswert und oder ein weiterer Funktionswert verwendet. Diese Funktionswerte werden entsprechend des beschriebenen Verfahrens ermittelt bzw. normiert.

In einer Ausgestaltung des Verfahrens kann ein Betreiber von Anlagen in der Mining-Industrie, also insbesondere der Betreiber eines Gurtförderers, die Performance der betrachteten Anlage bzw. deren Entwicklung zum Urzustand bewerten. Veränderungen an der Anlage und deren Auswirkungen (z.B. neuer Fördergurt, Tragrollenwechsel, Änderung von Start- und Stoppzeiten, Getriebewechsel) können schnell bewertet werden. Die Auswirkungen von durchgeführten Maßnahmen (z.B. neu Bauelemente in der Anlage, neue Betriebsweise) werden schnell sichtbar. Dieses Verfahren kann Betreiber dabei unterstützen die Performance seiner Anlage zu verbessern, bzw. deren Entwicklung bewusst zu verfolgen. Die Dimensionierung des Gurtförderers erfolgt beispielsweise unter Betrachtung einer kontinuierlichen Auslastung mit Nennlast und ggf. der Berücksichtigung von Extremfällen. Die Nutzung des digitalen Zwillings gestattet es, die aktuelle Betriebssituation z.B. Beladungssituation, Gurtgeschwindigkeit in die Bewertung mit einfließen zu lassen. Dadurch sind die Resultate einer "Was wäre, wenn?"- Betrachtung realistischer. Also wie würde sich der ursprünglich dimensionierte Gurtförderer unter den aktuellen Belade- und Geschwindigkeitsverhältnissen verhalten. Bei entsprechender Qualität des digitalen Zwillings könnten ggf. Einflüsse aus Verschleißverhalten oder Temperatureinwirkungen berücksichtigt werden. Die Bereitstellung von technischen Daten, z.B. für einen Instandhalter einer Anlage, ist ein weiterer Aspekt der Nutzung des digitalen Abbildes, also insbesondere eines digitalen Zwillings. Durch die Verbindung von technischen und wirtschaftlichen Daten kann diese Unterstützungsleistung weiter ausgebaut werden. In Verbindung mit der Automatisierung von Anlagen in Bulk-Material-Handling stellen derartige digitalen Lösungen eine Verbesserung des Betriebes von Anlagen dar.

Ein Gurtförderer weist insbesondere Sensoren zur Ermittlung von Sensordaten auf, wobei zur Ermittlung eines Funktionswertes zumindest ein Sensordatum verwendbar ist, wobei zur Analyse des Funktionswertes eines der beschriebenen Verfahren durchführbar ist. Zur Analyse ist beispielsweise eine speicherprogrammierbare Steuerung, ein Regelungssystem oder ein Monitoringsystem verwendbar.

In einer Ausgestaltung des Gurtförderers weist dieser ein Monitoringsystem auf. Das Monitoringsystem bietet beispielsweise auch die Möglichkeit Trendanalysen bereitzustellen. Die Ermittlung und/oder Analyse der Funktionswerte benötigt insbesondere Daten, die mittels eines Monitoringsystems bzw. entsprechender Sensoren bereitgestellt werden können. Das Verfahren zur Ermittlung und/oder Analyse des Funktionswertes kann Bestandteil des Monitoringsystems sein oder auch separat installiert werden.

Ein Computerprogrammprodukt ist zur Installation auf einer Recheneinheit vorgesehen, wobei das Computerprogrammprodukt zur Durchführung eines der beschriebenen Verfahren ausgebildet ist.

Im Folgenden wird die Erfindung anhand von Figuren beispielhaft näher beschrieben und erläutert. Die einzelnen Merkmale der in den Figuren gezeigten Ausführungen lassen sich fachmännisch zu neuen Ausführungsformen kombinieren, ohne den Rahmen der Erfindung zu verlassen. Gleiche Bezugszeichen bezeichnen dabei gleichartige Elemente. Es zeigen:
- FIG 1: ein Verfahren zur Analyse eines Gurtförderers,
- FIG 2: ein weiteres Verfahren zur Analyse eines Gurtförderers,
- FIG 3: ein weiteres Verfahren zur Analyse eines Gurtförderers unter Berücksichtigung eines Monitoring Systems,
- FIG 4: ein Verfahren zum Vergleich zweier Gurtförderer unter Verwendung einer Datenbank,
- FIG 5: ein Verfahren zum Vergleich zweier Gurtförderer unter Verwendung zweier Datenbanken,
- FIG 6: eine erste Darstellung eines Verlaufs von Energiekennzahlen,
- FIG 7: eine weitere Darstellung eines Verlaufs von Energiekennzahlen,
- FIG 8: eine erste Darstellung für einen Eingriff in den Betrieb des Gurtförderers,
- FIG 9: eine weitere Darstellung für einen Eingriff in den Betrieb des Gurtförderers,
- FIG 10: eine Abfolge von Bearbeitungsschritten unter vorgegebenen Bedingungen,
- FIG 11: Funktionsblöcke in einer Simulationssoftware,
- FIG 12: Antriebsleistung und Last auf dem Gurt über die Zeit,
- FIG 13: Zuordnungen zu Lastklassen,
- FIG 14: Energiekennzahlen über die Zeit,
- FIG 15: Detailansicht auf einen Beispielfunktionsblock und
- FIG 16: Schema für die Ermittlung von Funktionswerten.

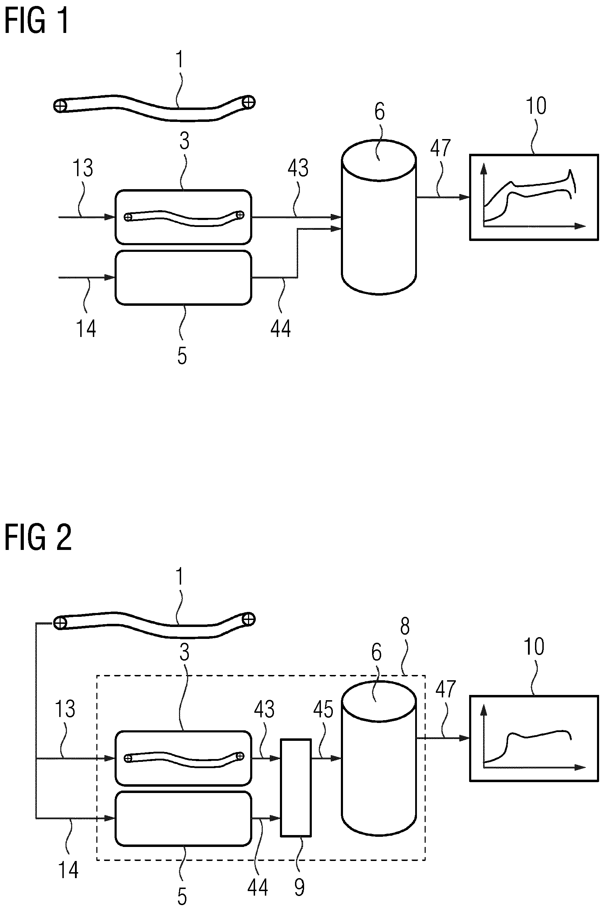

Die Darstellung nach Figur 1 zeigt ein Verfahren zur Analyse eines Gurtförderers 1. Der Gurtförderer 1 ist ein realer Gurtförderer. In einem Datenmodell 3 bzw. durch dieses ergibt sich ein normiertes digitales Abbild des realen Gurtförderers. Das digitale Abbild kann auch als digitaler Zwilling bezeichnet werden. Im Datenmodell 3 werden Messdaten, also reale Werte 13 des realen Gurtförderers 1, für z.B. die Geschwindigkeit des Gurtförderers und/oder die Beladung, also die Last des Gurtförderers, verwendet. In einem Normierungsmodul 5 erfolgt die Normierung realer Werte 14 nach einer Geschwindigkeit des Gurtförderers 1 und einer Beladungsklasse des Gurtförderers 1. Reale Werte bzw. reale Messwerte 13 sind also insbesondere die Geschwindigkeit und die Beladung für das Datenmodell 3. Reale Werte bzw. reale Messwerte 14 für das Normierungsmodul 5 sind insbesondere eine gemessene Leistung und die Beladung. Mit dem Datenmodell 3 wird ein Ergebniswert 43 ermittelt. Mit dem Normierungsmodul 5 wird ein Ergebniswert 44 ermittelt. Die Ergebniswerte 43 und 44 können bereits Funktionswerte sein. Die Ergebniswerte 43 und 44 werden in einer Datenbank 6 gespeichert. Mit den Ergebniswerten 43 und 44 kann auch erst ein Funktionswert oder auch ein weiterer Funktionswert ermittelt werden. Die Ermittlung erfolgt beispielsweise in der Datenbank 6 oder in einer weiteren nicht dargestellten Ermittlungseinrichtung. Die in der Datenbank gespeicherten Funktionswerte können in einem visuellen Abbild 10 visualisiert und/oder verglichen werden. Die Datenbank 6 stellt Visualisierungsdaten 47 bereit. Das Abbild bietet also die Möglichkeit einer Visualisierung, einer Analyse und/oder eines Vergleichs, insbesondere von realen Werten mit simulierten Werten. Funktionswerte sind beispielsweise Energiekennzahlen. Hieraus ergibt sich insbesondere ein Vergleich einer Entwicklung real gemessener Energiekennzahl mit Energiekennzahlen, welche durch eine Simulation mittels des Datenmodells 3 unter Zuhilfenahme von realen Messwerten 13, 14 ermittelt sind. Die realen Werte Geschwindigkeit und Beladung sind der Input, also die Eingangsgrößen, für das digitale Abbild, also das Datenmodell 3. Die benötigte Leistung (Power) wird berechnet und normiert. Durch die Verwendung der Beladung kann eine Unterscheidung in Beladungsklassen erfolgen. Gemäß dieser Normierung nach Beladungsklassen und Geschwindigkeit (Speed) werden die theoretischen Energiekennzahlen für die jeweilige Beladungsklasse ermittelt. Die ermittelten Funktionswerte können über die Zeit aufgetragen werden, um eine Entwicklung bzw. einen Trend abzubilden. Das digitale Abbild, also das Datenmodell, beschreibt z.B. einen Idealzustand oder Ausgangszustand des Gurtförderers. Insbesondere für einen Vergleich mit dem realen Gurtförderer hat ebenfalls eine Normierung zu erfolgen.

Die verbrauchte Energie (insbesondere ein Messwert, bzw. errechnet aus Messwerten) wird insbesondere nach Geschwindigkeit und den Belastungsklassen normiert und die realen Energiekennzahlen für die jeweiligen Belastungsklassen bestimmt. Die Differenz der Ergebnisse zwischen theoretischen und realen Energiekennzahlen beschreibt den Anlagenzustand. Eine Visualisierung der Analyse bzw. des Vergleiches zumindest eines realen Funktionswertes mit einem simulierten Funktionswert erfolgt insbesondere durch ein visuelles Abbild 10 mittels einer Visualisierungsvorrichtung, wie dies beispielsweise ein Bildschirm ist.

Die Darstellung nach Figur 2 zeigt ein weiteres Verfahren zur Analyse eines Gurtförderers 1, wobei ein erster Funktionswert 45 in einem Verarbeitungsmodul 9 aus den Ergebniswerten 43 und 44 berechnet wird. Nach Figur 2 ist das Datenmodell 3, das Normierungsmodul 5 und die Datenbank 6 in einer Cloud 8 realisiert. Die Cloud 8 ist ein internetbasiertes System. Berechnungen in der Cloud, wie auch die Speicherung von Daten in der Cloud, können zentral oder dezentral erfolgen. Die Visualisierung 10 der Analyse kann beispielsweise auf einer Anlage erfolgen, also insbesondere dort, wo sich auch der Gurtförderer 1 befindet.

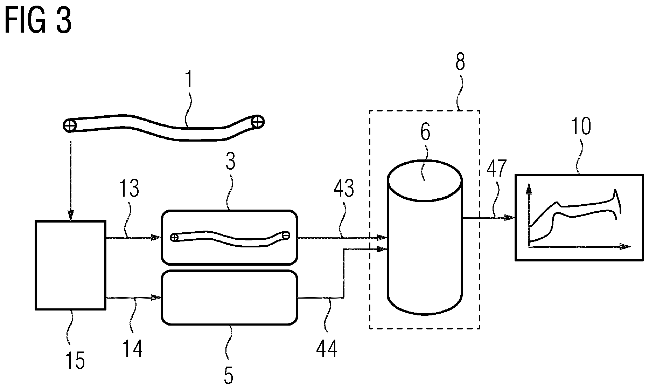

Die Darstellung nach Figur 3 zeigt ein weiteres Verfahren zur Analyse eines realen Gurtförderers 1, wobei die realen Werte (Messwerte) 13 und 14 aus einem Monitoringsystem 15 entnommen werden. Das Monitoringsystem 15 überwacht den Gurtförderer 1. Im Normierungsmodul 5 erfolgt eine Normierung der realen Werte nach Geschwindigkeit und Beladungsklasse. Im Datenmodell 3 ist ein digitales Abbild des realen Gurtförderers realisiert, wobei dieses normiert ist. Normiert bedeutet hier normiert nach Geschwindigkeit und Beladungsklasse. Die Datenbank 6 ist in der Cloud 8 realisiert. Mittels der visuellen Darstellung 10 kann ein Vergleich herbeigeführt werden. So kann beispielsweise die Entwicklung der Energiekennzahl real gemessen und simuliert verglichen werden, wobei zur Simulation reale Werte als Input verwendet werden.

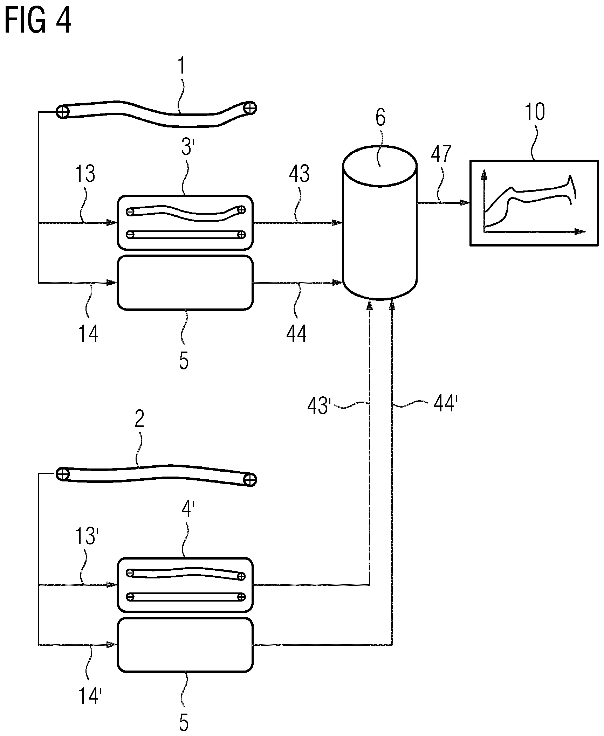

Die Darstellung nach Figur 4 zeigt ein Verfahren zum Vergleich zweier Gurtförderer, einem ersten Gurtförderer 1 und einem zweiten Gurtförderer 2, unter Verwendung einer gemeinsamen Datenbank 6. Nach Figur 4 wird im Vergleich zum Beispiel nach Figur 1 zusätzlich nach dem Hub normiert, um die unterschiedlichen Gurtförderer miteinander vergleichen zu können. Dem Gurtförderer 1 ist das Datenmodell 3', welches auch nach dem Hub normiert, und das Normierungsmodul 5 zugeordnet. Dem Gurtförderer 2 ist das Datenmodell 4', welches auch nach dem Hub normiert, und ein weiteres Normierungsmodul 5 zugeordnet. Aus dem Gurtförderer 2 ergeben sich die realen Messwerte 13' und 14'. Die Datenmodelle 3'und 4' unterscheiden sich von den Datenmodellen nach Figur 1 bis 3 durch eine zusätzliche Normierung nach dem Hub des jeweiligen Gurtförderers 1 bzw. 2. Im Symbol für das Datenmodell 3, 3' ist der Gurtförderer deswegen auch zusätzlich gerade gezeichnet, da eine Normierung vorliegt. Der Hub ist ein Maß für die Steigungen (positiv wie auch negativ), welche von dem Gurtförderer zu überwinden sind. Nach Figur 4 erfolgt also auch eine Normierung nach dem Hub, um insbesondere unterschiedliche Gurtförderer miteinander vergleichen zu können, welche insbesondere unterschiedliche Höhenprofile zu überwinden haben. Die Normierung erfolgt demnach nach der Geschwindigkeit, der Beladungsklasse und dem Hub. Auch hier ist der Einsatz eines Monitoringsystems möglich, jedoch nicht dargestellt. Die Datenmodelle 3' und 4' erzeugen Ergebniswerte 43 und 43'. Die jeweiligen Normierungsmodule 5 erzeugen Ergebniswerte 44 und 44'. Über die Daten in der Datenbank 6 können unterschiedliche Gurtförderer in einem Werk, einem Tagebau oder einer Mine verglichen werden.

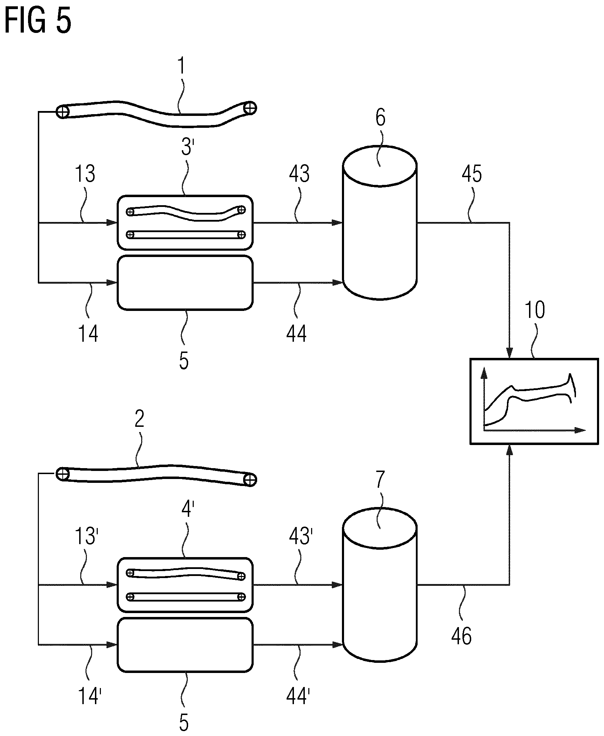

Die Darstellung nach Figur 5 zeigt im Unterschied zu Figur 4 ein Verfahren zum Vergleich zweier Gurtförderer 1 und 2 unter Verwendung zweier Datenbanken 6 und 7. Dem Gurtförderer 1 ist die Datenbank 6 zugeordnet. Dem Gurtförderer 2 ist die Datenbank 7 zugeordnet. Ein erster Funktionswert 45 der Datenbank 6 kann mit einem zweiten Funktionswert 46 der Datenbank 7 verglichen werden. Die Normierung erfolgt nach Geschwindigkeit, Beladung (Beladungsklasse) und Hub. Die Darstellung 10 ist beispielsweise auch durch ein Monitoringsystem möglich, welches nicht dargestellt ist.

Nach den Figuren 4 bzw. 5 kann also ein Vergleich unterschiedlicher Gurtförderer in einem Industriewerk, einem Tagebau bzw. einer Mine erfolgen oder auch in verschiedenen Werken, verschiedenen Tagebauen bzw. verschiedenen Minen. Hierzu kann die Anzahl der Datenbanken 6,7 entsprechend angepasst werden.

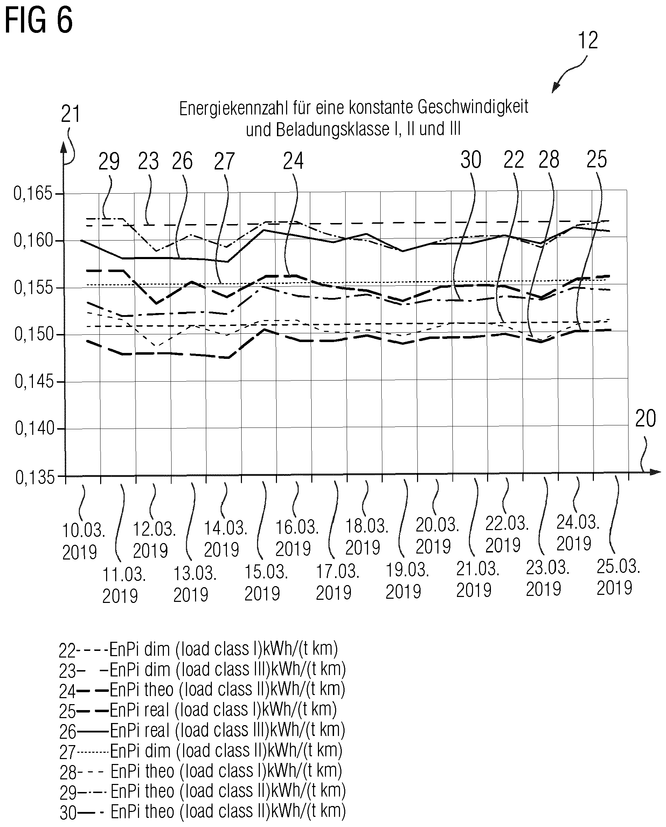

Die Darstellung nach Figur 6 zeigt einen Vergleich 12 von Energiekennzahlen (EnPI: Energie Performance Indicator) als ein Beispiel für Funktionswerte. Dargestellt werden folgende Energiekennzahlen bei einer konstanten Geschwindigkeit (z.B. von 50 % oder 80 % der Nenngeschwindigkeit) und drei unterschiedlichen Beladungsklassen I, II und III. Die Werte (Daten) 21 folgender Energiekennzahlen sind über die Zeit 20 (Datum) aufgetragen, wobei die Werte Eigenschaften haben wie: real, theoretisch (vorhergesagt) und dimensioniert (dim (steht für Dimensionierung, also für eine ursprüngliche Auslegung des betrachteten Gurtförderers)):
22 EnPi dim (Beladungsklasse I) kWh/(t*km)
23 EnPi dim (Beladungsklasse III) kWh/(t*km)
24 EnPi theo (Beladungsklasse II) kWh/(t*km)
25 EnPi real (Beladungsklasse I) kWh/(t*km)
26 EnPi real (Beladungsklasse III) kWh/(t*km)
27 EnPi dim (Beladungsklasse II) kWh/(t*km)
28 EnPi theo (Beladungsklasse I) kWh/(t*km)
29 EnPi theo (Beladungsklasse III) kWh/(t*km)
30 EnPi real (Beladungsklasse II) kWh/(t*km)

Dies ist ein Beispiel für die Darstellung von Ergebnissen der theoretischen und realen Energiekennzahl über die Zeit für drei Beladungsklassen. Gemäß der Normierung werden diese Energiekennzahlen normiert nach Geschwindigkeit (viele Gurtförderer arbeiten mit einer konstanten Geschwindigkeit (fixed speed), weniger mit variabler Geschwindigkeit) und den Beladungsklassen. Der EnPi dim kann auch für verschieden Beladungsklassen berechnet werden. Dieser Wert ist ein theoretischer Wert basierend auf Dimensionierungsberechnungen. Arbeitet der Gurtförderer mit variabler Geschwindigkeit, kann die Normierung nach den verschiedenen Geschwindigkeiten, Beladungsklassen und ggf. auch Hub erfolgen, wobei eine derartige Ergebnisdarstellung beispielsweise dreidimensional erfolgt bzw. mittels einer Matrix, was in Figur 6 nicht dargestellt ist.

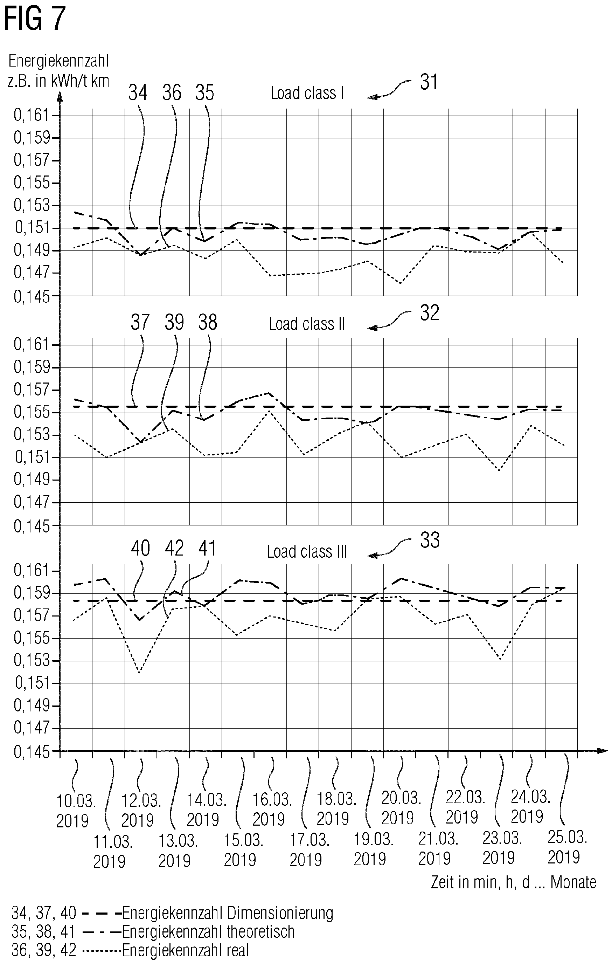

Die Darstellung nach Figur 7 zeigt einen weiteren Vergleich von Energiekennzahlen abhängig von den Beladungsklassen. Die Energiekennzahl (z.B. in kWh/t*km) wird über die Zeit (z.B. in Minuten (min), Stunden (h), Tagen (d) oder Monaten) dargestellt. Die Darstellung unterscheidet die Beladungsklassen I (load class I) 31, II (load class II) 32 und III (load class III) 33. Die Energiekennzahlen 34, 37 und 40 basieren auf der ursprünglichen Auslegung, d.h. auf der Dimensionierungsberechnung des Gurtförderers. Die Energiekennzahlen 35, 38 und 41 sind theoretisch und die Energiekennzahlen 36, 39 und 42 sind real. Theoretisch bedeutet, sie wurden in dem Datenmodel, d.h. im digitalen Zwilling ermittelt.

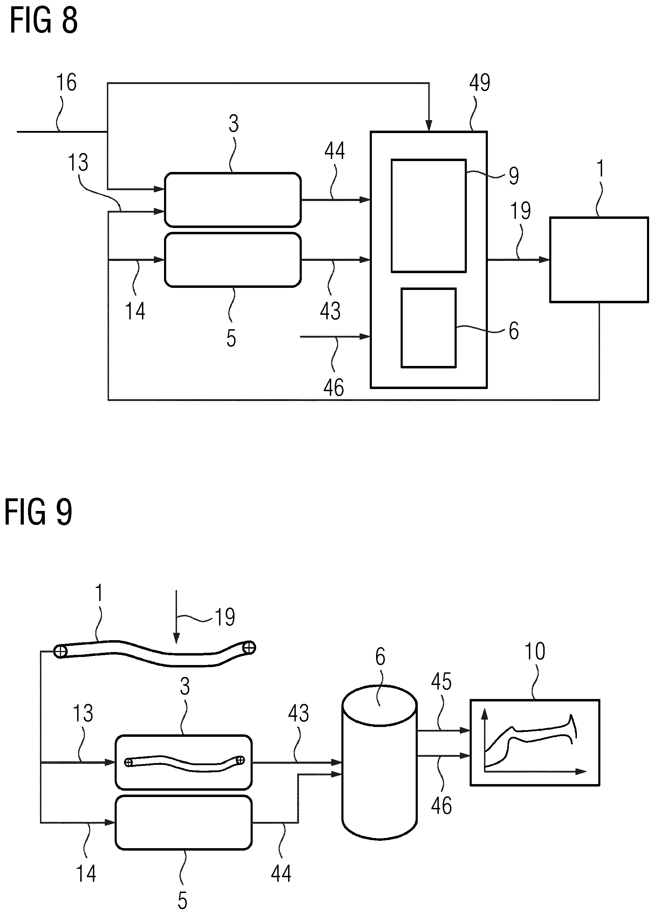

Die Darstellung nach Figur 8 zeigt die Bewertung der Auswirkungen eines Eingriffs 19 in eine reale Anlage, also den Gurtförderer 1. Der Eingriff 19 erfolgt auf Basis einer Analyse in einer Analyseeinrichtung 49. In der Analyseeinrichtung 49 werden auf Basis eines Verarbeitungsmoduls 9 und einer Datenbank 6 Funktionswerte analysiert und ein Eingriff 19 in den Gurtförderer erzeugt. In der Analyseeinrichtung 49 werden auch Anlagendaten 16 verarbeitet. Sensordaten 11 ergeben z.B. die Messwerte 13 und 14.

Die Darstellung nach Figur 9 zeigt, wie ein Eingriff 19 analysiert werden kann. Das beschriebene Verfahren kann zur Bewertung von durchgeführten Eingriffen genutzt werden. Eingriffe sind Änderungen am realen Gurtförderer 1. Mit der Ermittlung von Funktionswerten kann die Wirksamkeit eines Eingriffes bewertet werden. Ein Eingriff ist beispielsweise eine geringere Beladung oder auch eine höhere Beladung des Gurtförderers oder ein Gurtwechsel.

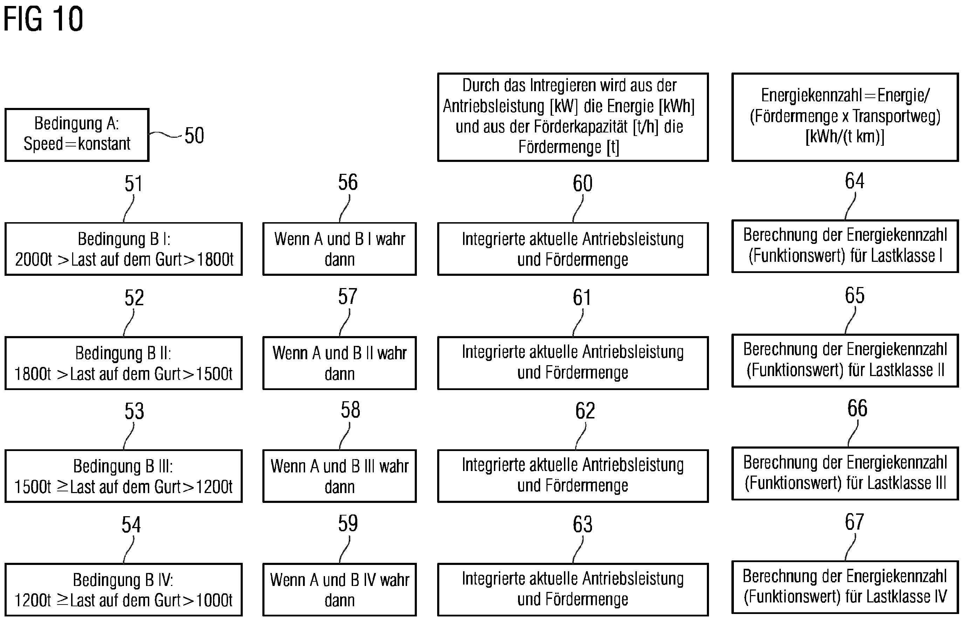

Die Darstellung nach Figur 10 zeigt eine Abfolge von Bearbeitungsschritten unter vorgegebenen Bedingungen. Gezeigt sind folgende Elemente:
50: Bedingung A mit konstantem Speed (konstanter Geschwindigkeit)
51: Bedingung B I mit
   2000t > Last auf dem Gurt 1800t
52: Bedingung B II mit
   2000t > Last auf dem Gurt 1800t
53: Bedingung B III mit
   2000t > Last auf dem Gurt 1800t
54: Bedingung B IV mit
   2000t > Last auf dem Gurt 1800t
56: Wenn A und B I wahr dann
57: Wenn A und B II wahr dann
58: Wenn A und B III wahr dann
59: Wenn A und B IV wahr dann
60,61,62,63: Integriere aktuelle Antriebsleistung und Förderelement
64: Berechnung der Energiekennzahl (Funktionswert) für die Lastklasse I
65: Berechnung der Energiekennzahl (Funktionswert) für die Lastklasse II
66: Berechnung der Energiekennzahl (Funktionswert) für die Lastklasse III
67: Berechnung der Energiekennzahl (Funktionswert) für die Lastklasse IV

Durch das Integrieren wird aus der Antriebsleistung [kW] die Energie [kWh] und aus der Förderkapazität [t/h] die Fördermenge [t]. Die Energiekennzahl berechnet sich aus der Energie geteilt durch (Fördermenge * Transportweg)[kWh/(t*km)].

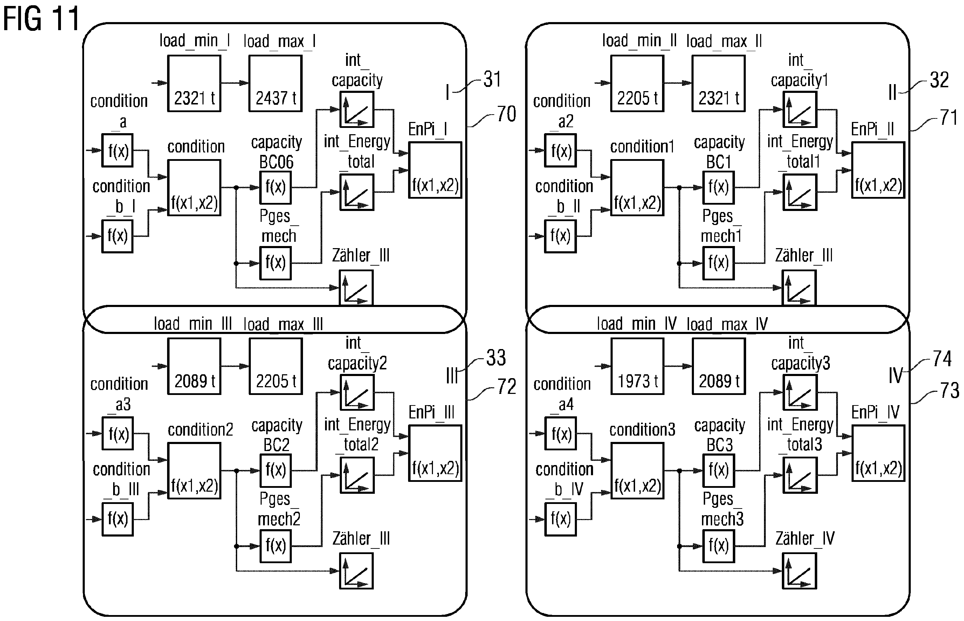

Die Darstellung nach Figur 11 zeigt Funktionsblöcke 70,71,72 und 73 in einer Simulationssoftware zur Ermittlung von Energiekennzahlen für vier Lastklassen:
- I 31,
- II 32
- III 33
- IV 74.

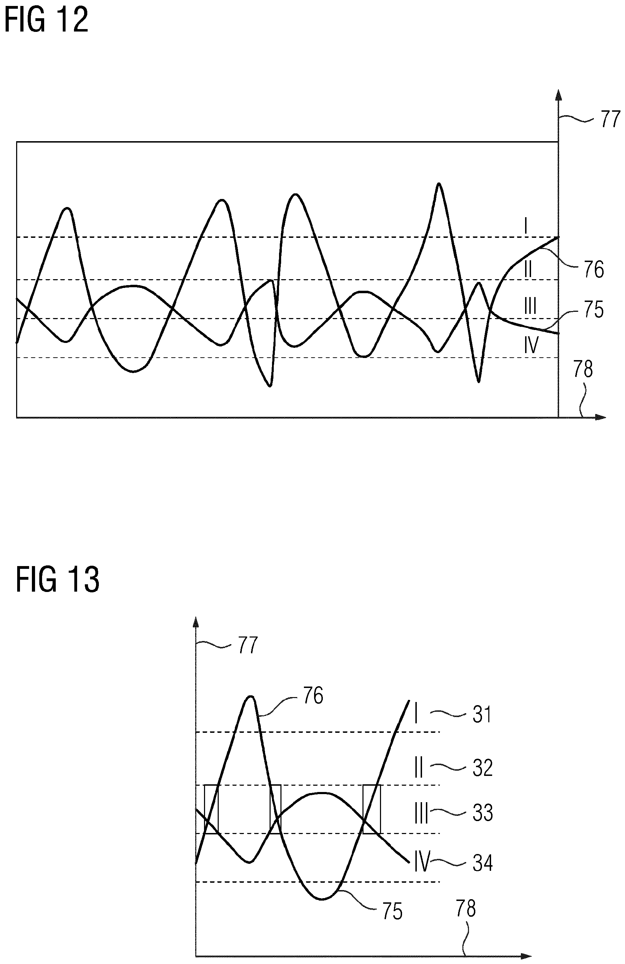

Die Darstellung nach Figur 12 zeigt für einen Gurtförderer die Werte 77 für die Antriebsleistung 75 und Last 76 auf dem Gurt über die Zeit 78 geteilt in die Lastklassen I, II, III und IV. Eine Randbedingung dabei ist eine konstante Geschwindigkeit, wie z.B. 40 %, 100 % oder 110 % der Nenngeschwindigkeit.

Die Darstellung nach Figur 13 zeigt Zuordnungen zu Lastklassen. Betrachtet wird beispielsweise die Lastklasse III, also die Zeit, in der die Last 76 in dieser Klasse ist. Daraus ergibt sich die Erkenntnis über die Antriebsleistung 75 die in der gleichen Zeit verbraucht wird. Die dazu gehörende Förderleistung wird der Klasse III zugeordnet, um dann damit die Energiekennzahl zu bestimmen. Der Betrachtete Bereich in der Klasse III ist grau hinterlegt.

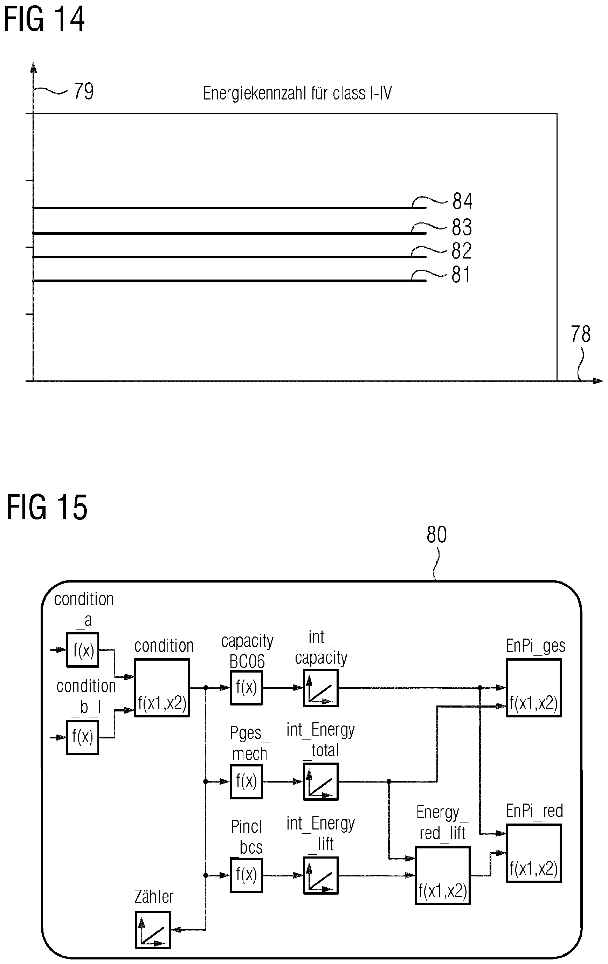

Die Darstellung nach Figur 14 zeigt den in etwa parallelen Verlauf der Werte 79 von Energiekennzahlen unterschiedlicher Klassen 1 bis IV:
81 EnPI_I
82 EnPI_II
83 EnPI_III
84 EnPI_IV
über die Zeit 78. Dies zeigt einem Nutzer, dass sich in diesem Zeitraum an dem Gurtförderer nichts Maßgebliches verändert hat.

Die Darstellung nach Figur 15 zeigt eine Detailansicht auf einen Beispielfunktionsblock 80. Für jede Lastklasse ist ein Funktionsblock vorgesehen. Es erfolgt eine Berücksichtigung der Normierung nach dem Hub, d.h. insbesondere eine Reduzierung um die Hubarbeit. Zusätzlich zu der Darstellung der Funktionsblöcke in Figure 11 ist hier die weitere Normierung nach dem Hub mit dargestellt.

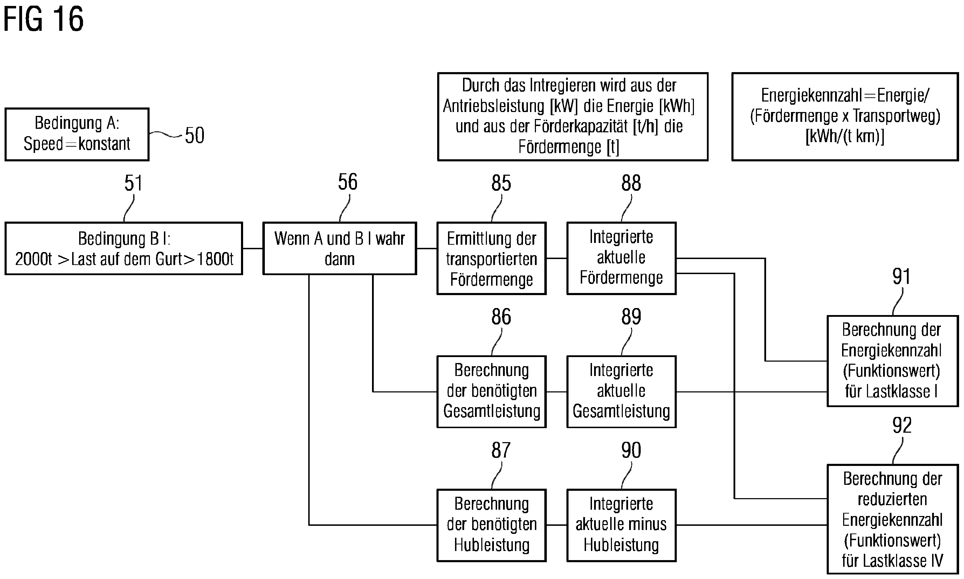

Die Darstellung nach Figur 16 zeigt ein Schema für die Ermittlung von Funktionswerten für eine Lastklasse, und zwar einmal als Gesamtwert und einmal reduziert um die Hubleistung, d.g. normiert auf die Hubhöhe (Hub = 0m).

Gezeigt sind folgende Elemente:
50: Bedingung A mit konstantem Speed (konstante Geschwindigkeit)
51: Bedingung B I mit
   2000t > Last auf dem Gurt 1800t
56: Wenn A und B I wahr dann
85: Ermittlung der transportierten Fördermenge
86: Berechnung der benötigten Gesamtleistung
87: Berechnung der benötigten Hubleistung
88: Integrierte aktuelle Fördermenge
89: Integrierte aktuelle Gesamtleistung
90: Integrierte aktuelle Gesamtleistung minus Hubleistung
91: Berechnung der Energiekennzahl (Funktionswert) für die Lastklasse I
92: Berechnung der reduzierten Energiekennzahl (Funktionswert) für die Lastklasse I.

Durch das Integrieren wird aus der Antriebsleistung [kW] die Energie [kWh] und aus der Förderkapazität [t/h] die Fördermenge [t]. Die Energiekennzahl berechnet sich aus der Energie geteilt durch (Fördermenge * Transportweg)[kWh/(t*km)].

## Patentansprüche

1. Verfahren zur Analyse eines Gurtförderers (1), wobei ein Datenmodell (3) verwendet wird,
wobei das Datenmodell (3) ein digitales Abbild des Gurtförderers (1) betrifft,
wobei ein erster Funktionswert (45) des Gurtförderers (1) ermittelt wird,
wobei der erste Funktionswert (45) und ein zweiter Funktionswert (46) zur Analyse des Gurtförderers verwendet werden, wobei der zweite Funktionswert (46) den Gurtförderer (1) oder einen weiteren Gurtförderer (2) betrifft,
wobei die Funktionswerte (45,46) in einem zeitlichen Abstand ermittelt werden oder wobei die Funktionswerte (45,46) unterschiedliche Gurtförderer (1,2) betreffen.

2. Verfahren nach Anspruch 1, wobei zur Analyse eine Normierung durchgeführt wird, wobei insbesondere der Funktionswert (45,46) normiert wird oder ist.

3. Verfahren nach Anspruch 2, wobei auf einen Betriebszustand normiert wird.

4. Verfahren nach Anspruch 2 oder 3, wobei auf einen Kennwert eines Materials normiert wird, wobei der Kennwert insbesondere das Gewicht und/oder die Menge des Materials betrifft.

5. Verfahren nach einem der Ansprüche 2 bis 4, wobei auf eine Hubhöhe normiert wird.

6. Verfahren nach einem der Ansprüche 2 bis 5, wobei die Normierung den ersten Funktionswert (45) des Gurtförderers (1) und den zweiten Funktionswert (46) des weiteren Gurtförderers (2) betrifft.

7. Verfahren nach einem der Ansprüche 1 bis 6, wobei sich die Gurtförderer (1,2) in ihrer Länge und/oder Förderleistung nicht um mehr als 50 % unterscheiden, wobei die Gurtförderer (1,2) insbesondere ähnliche Transportaufgaben haben.

8. Verfahren nach einem der Ansprüche 1 bis 7, wobei der Funktionswert eine Energieleistungskennzahl ist.

9. Verfahren nach einem der Ansprüche 1 bis 8, wobei eine technische Abweichung und/oder eine technische Störung erkannt wird.

10. Verfahren nach einem der Ansprüche 1 bis 9, wobei eine prozessuale Abweichung und/oder Störung erkannt wird.

11. Verfahren nach einem der Ansprüche 1 bis 10, wobei ein Eingriff in den Betrieb des Gurtförderers (1,2) durchgeführt wird.

12. Verfahren nach einem der Ansprüche 1 bis 11, wobei die Wirksamkeit des Eingriffs analysiert wird.

13. Gurtförderer (1) mit Sensoren zur Ermittlung von Sensordaten (9), wobei zur Ermittlung eines Funktionswertes (45) zumindest ein Sensordatum verwendbar ist, wobei zur Analyse des Funktionswertes (45) ein Verfahren nach einem der Ansprüche 1 bis 12 durchführbar ist.

14. Gurtförderer (1) nach Anspruch 13, wobei dieser ein Monitoringsystem (15) aufweist.

15. Computerprogrammprodukt zur Installation auf einer Recheneinheit, wobei das Computerprogrammprodukt zur Durchführung eines Verfahrens gemäß einem der Ansprüche 1 bis 12 ausgebildet ist.
